# EUROPÄISCHE PATENTSCHRIFT

(11) **EP 1 663 892 B1**
(45) Veröffentlichungstag und Bekanntmachung des Hinweises auf die Patenterteilung: **07.03.2007**
(21) Anmeldenummer: 04763587.5
(22) Anmeldetag: 29.07.2004
(51) Int. Cl.: C03C 17/22, C03C 17/245, C23C 14/58, C03C 17/00

(54) **VERFAHREN ZUR HERSTELLUNG VON SUBSTRATEN MIT TEMPERATURBESTÄNDIGEN SCHUTZSCHICHTEN**
METHOD FOR PRODUCING SUBSTRATES COMPRISING TEMPERATURE-RESISTANT PROTECTIVE COATINGS
PROCEDE POUR PRODUIRE DES SUBSTRATS PRESENTANT DES COUCHES PROTECTRICES RESISTANT A LA CHALEUR

(30) Priorität: 13.09.2003 DE 10342398
(43) Veröffentlichungstag der Anmeldung: 07.06.2006
(73) Patentinhaber: Schott AG, 55122 Mainz (DE)
(72) Erfinder: DZICK, Jürgen, 30926 Seelze (DE); GABEL, Falk, 65388 Schlangenbad (DE)
(74) Vertreter: Herden, Andreas F.
(86) Internationale Anmeldenummer: PCT/EP2004/008481
(87) Internationale Veröffentlichungsnummer: WO 2005/028390

(56) Entgegenhaltungen:
- EP-A- 0 522 872
- GB-A- 2 028 376
- US-A- 3 483 110
- US-A- 5 011 585
- US-A- 5 473 456
- TOMASZEWSKI H ET AL: "Yttria-stabilized zirconia thin films grown by reactive r.f. magnetron sputtering" 30. Oktober 1996 (1996-10-30), THIN SOLID FILMS, ELSEVIER-SEQUOIA S.A. LAUSANNE, CH, PAGE(S) 104-109 , XP004049478 ISSN: 0040-6090 das ganze Dokument

## Beschreibung

Die Erfindung bezieht sich auf ein Verfahren zur Herstellung von Substraten mit Schutzschichten, insbesondere zur Herstellung von Substraten mit Schutzschichten mit hoher Kratzfestigkeit und Temperaturbeständigkeit. Die Erfindung bezieht sich im speziellen auf ein Verfahren zur Herstellung von Glaskeramikplatten mit einer kratzfesten und temperaturbeständigen Schutzschicht, welche vorzugsweise als Kochflächen in Kochfeldern dienen.

### Beschreibung

Moderne Kochfelder besitzen eine Glaskeramikplatte als Kochfläche, wobei die Glaskeramikplatte typischerweise plan ist, aber auch zwei oder dreidimensional verformt sein kann. Es sind sowohl Glaskeramikplatten druckschriftlich bekannt bzw. auf dem Markt, die undekoriert oder mit temperaturstabilen Farben, z.B. keramischen Farben, dekoriert sind. Die Kochfläche weist einzelne Kochzonen auf, die induktiv, mit elektrisch betriebenen Strahlungsheizkörpern, mit Gasstrahlungsheizelementen oder mit alternativen Heizsystemen (z.B. DHS von SCHOTT) beheizt werden.

Glaskeramikplatten haben typischerweise eine Mohshärte mit einem Härtegrad von 5 - 6, der vergleichbar dem von Stahl ist, aus dem typischerweise das Kochgeschirr hergestellt wird. Der alltägliche Gebrauch, d.h. Abstellen bzw. Verschieben des Kochgeschirres sowie beim Reinigen der Kochflächen mit abrasiven Reinigungsmitteln und Schwämmen bzw. mit einem Schaber stellt eine hohe mechanische Belastung des Kochfeldes dar, die dazu führen kann, Gebräuchsspuren auf dem Kochfeld hervorzurufen.

Hinzu kommt, dass die Kochfläche in kaltem Zustand häufig als zusätzliche Abstellfläche Verwendung findet. Gerade hier besteht ein erhöhtes Risiko der Ausbildung von Oberflächenschädigungen beispielsweise durch rauhe Böden keramischer Gegenstände. Alle entstehenden Oberflächenschädigungen führen im Laufe der Zeit zur Ausbildung einer Verkratzung der Oberfläche, die in Abhängigkeit von der gewählten Beleuchtung mehr oder weniger stark für den Beobachter auffällig wird. Hinzu kommt, dass Schädigungen der Oberfläche Ansatzpunkte für Verschmutzungen bieten. Die leichte Reinigbarkeit der Oberfläche wird eingeschränkt, da die Abreinigung von Verschmutzungen aus diesen Schädigungen deutlich erschwert ist. Dieser Effekt ist unabhängig davon, ob das Kochfeld transparent, farbig oder transluzent ist.

Die Glaskeramikplatten der früheren Generation besaßen eine orangenhautähnliche typische Oberflächenstruktur. Obwohl auch diese Platten durch oben beschriebene Vorgänge verkratzt wurden, boten sie aufgrund der zusätzlichen Oberflächenstruktur eine relativ geringe Kratzerauffälligkeit. Die Oberflächen der Glaskeramikplatten sind jedoch im Laufe der Zeit glatter und glänzender geworden, was aus den vorgenannten Gründen zu einer verstärkten Kratzerauffälligkeit führt.

Die EP 0 716 270 B1 beschreibt eine Kochfläche aus Glaskeramik, auf deren Oberseite ein Dekor vorgesehen ist, die zum Vermeiden von Kratz- bzw. Gebrauchsspuren eine Schutzschicht in Form einer Emailflüsse oder Silikatbeschichtung mit einer gegenüber der Glaskeramik erhöhten Kratzfestigkeit besitzt, wobei diese Schutzschicht die Glaskeramikkochfläche geschlossen bzw. möglichst geschlossen bedeckt, und auf diese Schutzschicht oder direkt auf die Glaskeramikoberfläche ein Dekor aufgedruckt ist. Bevorzugt ist die Schutzschicht aus einem dunklen Material ausgebildet. Durch diese Schutzschicht wird zwar die mechanische Belastbarkeit der Glaskeramikkochflächen grundsätzlich erhöht, so dass im Gebrauch der Kochfläche eine verminderte Kratzerauffälligkeit gegenüber einer ungeschützten Kochfläche auftritt, jedoch bieten die allein in der EP Schrift offenbarten Emailflüsse- bzw. Silikatschutzschichten noch keinen optimalen mechanischen Langzeitschutz. Nachteilig ist nämlich, dass die Schutzschicht selbst ein Dekor darstellt, das mittels Siebdruck aufgebracht wird. Diese Dekorfarben basieren in der Regel auf den gleichen Flüssen wie die zur optischen Gestaltung verwendeten Dekorfarben. Hinsichtlich Abrieb unterliegen sie damit gleichen Restriktionen. Die minimale Abmessung derartiger Dekore beträgt in der Größenordnung 0,5 mm, was auf jeden Fall optisch auffällig ist und somit designerisch störend ist, insbesondere wenn Gläser oder Glaskeramiken mit glatten Oberflächen gewünscht sind.

Ferner lassen die Ausführungen keinerlei Rückschluss darauf zu, inwieweit die vorgestellte Lösung mit den verwendeten Heizersystemen kompatibel ist. Gerade die Verwendung von bevorzugt dunklen Materialien als Schutzschicht für Glaskeramiken mit hoher IR-Transparenz und Strahlungsheizkörpern wird zu einer Beschränkung der gewollten IR-Transparenz und damit zu Einbußen hinsichtlich der Ankochperformance führen.

In der DE 100 00 663 A1 wird ein Verfahren und die zugehörige Vorrichtung beschrieben, mit denen ein optisch transparenter Körper mit einer Kratzschutzschicht aus Al₂O₃ ganzflächig mittels eines modifizierten PICVD Verfahrens (PICVD - Plasma Impulse Chemical Vapor Deposition) versehen wird, derart, dass sich eine Hartstoffschicht ausbildet, da es sich gezeigt hat, dass mit den bekannten Verfahren keine ausreichend harte, dichte, kratzfeste sowie temperaturbeständige Schicht, insbesondere aus Aluminiumoxid, zu erzeugen ist. Nachteilig ist der große Verfahrensaufwand, insbesondere wenn großflächige Beschichtungen homogen aufgebracht werden müssen. Bisher sind Inhomogenitäten nicht vermeidbar, was zudem das optische Erscheinungsbild nachhaltig stört.

Ferner beschreibt WO 96/31995 eine induktiv beheizte Glas- oder Glaskeramikkochfläche mit integrierten Spulen, auf der eine Hartstoffschicht aus Al₂O₃ mittels der Technik des Plasmasprühens in einer Schichtdicke zwischen 50 und 200 µm aufgebracht ist. Nachteilig ist hierbei, dass derart dicke Schichten sehr rauh sind und damit die Gebrauchseigenschaften, wie Topfabrieb, Handabrieb sowie das Reinigungsverhalten nachteilig beeinflusst werden. Weiterhin ändert sich das Erscheinungsbild der Kochflächen mit einer solchen Schicht gänzlich. Die Oberfläche erscheint matt und grau.

Durch die DE 42 01 914 A1 (= US 5,594,231) ist es ferner bekannt, Abtastfenster aus Glas oder Glaskeramik von in Kassen von Supermärkten und anderen Verbrauchermärkten installierten Abtastsystemen zum Erfassen von auf den Warenverpackungen aufgebrachten Strichkodes, oberseitig mit einer lichtdurchlässigen Hartmaterial-Schicht, auf der wiederum eine lichtdurchlässige gleitfähige Beschichtung aufgebracht ist, zu versehen, um dieses Abtastfenster verschleißfester zu machen. Als Materialien für die Hartstoffschicht werden u.a. Metalloxide wie Al₂O₃, ZrO₂, SnO₂, Y₂O₃ genannt. Als besonders geeignet wird amorph abgeschiedenes Aluminiumoxid genannt. Gerade die amorphe Abscheidung des Metalloxides begünstigt hier die gewünschten besseren Härte- und Gleiteigenschaften der Schutzschicht. Die hier beschriebenen Hartstoffschichten sind für Anwendungen im Raumtemperaturbereich geeignet, verändern jedoch ihre Eigenschaften bei hohen Temperaturen, wie sie beispielsweise bei Kochflächen üblich sind, was sie für Verwendung bei hohen Temperaturen ungeeignet macht. Eine Schutzschicht für Kochflächen erfordert Materialien, die bis zu 800° C temperaturbeständig sind und die die hohen, zwischen der Glaskeramik und Schutzschicht auftretenden thermo-mechanischen Spannungen auszuhalten vermögen.

Durch die DE 201 06 167 U1 ist ein Kochfeld mit einer Glaskeramikplatte als Kochfläche bekannt geworden, die mit einer transparenten Kratzschutzschicht versehen ist, die u.a. durch eine Hartstoffschicht gebildet werden kann. Als Materialien für diese transparente Schicht werden u.a. Metalloxide wie Aluminiumoxid, Zirkonoxid, Yttriumoxid, Zinnoxid, Indiumoxid und Kombinationen daraus genannt. Das Abscheiden der Materialien kann nach dieser Schrift z.B. durch die SOL-GEL-Technik, die CVD-Verfahren, insbesondere durch das PICVD Verfahren und durch Sputtern erfolgen.

Die mit den bekannten Verfahren hergestellten Schutzschichten zeigen im Fall maximaler thermischer Belastung nachteilige Veränderungen, insbesondere Rissbildungen und/oder Verfärbungen durch thermisch induzierte Kompaktierung. Dadurch bietet die Schicht keinen besonderen Kratzschutz mehr und wird optisch unansehnlich.

Um beispielsweise Zirkonoxid eine höhere Temperaturbeständigkeit zu verleihen, ist es bekannt (G.Wehl et al., Proc. CVD-VII, 536 (1979)) diesem sogenannte Stabilisatoren aus Yttriumoxid, Magnesiumoxid oder Calziumoxid zuzufügen. Jedoch hat eine solche Schicht, hergestellt mit den bekannten Verfahren, eine geringe Dichte, so dass eine solche Schicht porös und wenig kratzfest ist.

Das in der US 4 920 014 beschriebene Verfahren zur Herstellung einer solchen Schicht aus stabilisierten Zirkonoxid versucht dieses Problem dadurch zu lösen, dass mittels des CVD-Verfahrens und genau eingestellter Verfahrensparameter wie Temperatur des Substrates, Zeitpunkt und Dauer der Zuführung der Reaktionssubstanzen etc. die Schicht so abgeschieden wird, dass sie nur noch eine oder zwei parallel zur Substratoberfläche orientierte Kristallebenen aufweist. Abgesehen von einem sehr hohen verfahrensaufwand, weisen derart kristalline Schichten noch immer eine raue Oberfläche auf.

Raue und poröse Oberflächen verschmutzen schnell und sind schwer zu reinigen. Sie sind außerdem optisch nicht klar transparent, sondern stark streuend und für Anwendungen mit optisch ansprechenden Oberflächen nicht geeignet.

Bei anderen optisch transparenten Körpern aus Glas oder Glaskeramik, die hohen Einsatztemperaturen ausgesetzt sind, z.B. Kaminsichtscheiben, Backofenscheiben für Pyrolyseherde etc., sind die Kratzschutz- und Temperaturprobleme ähnlich gelagert wie bei Kochflächen.

Der Erfindung liegt die Aufgabe zugrunde, einen Körper, insbesondere eine Glas- oder Glaskeramikplatte, zur Verfügung zu stellen, welcher temperaturstabil, kratz- und verschleißfest ist sowie eine dauerhaft glatte und optisch ansprechende Oberfläche aufweist.

Die Lösung dieser Aufgabe gelingt mit einem Verfahren gemäß Anspruch 1, vorteilhafte Weiterbildungen sind in den weiteren Ansprüchen beschrieben.

Das erfindungsgemäße Verfahren zum Herstellen eines Substrates mit zumindest einer Schutzschicht umfasst zumindest die Schritte:
- Bereitstellen des Substrates und zumindest eines Schichtausgangsstoffes in einer Vakuumkammer,
- Beschichten des Substrates mittels eines reaktiven PVD-Prozesses bei einer Beschichtungstemperatur T_{Dep}, wobei zumindest ein Reaktivgas in die Vakuumkammer eingeleitet wird und mit den Schichtausgangsstoff oder -stoffen ein Reaktionsprodukt bildet, welches als unterstöchiometrische Schicht auf dem Substrat abgeschieden wird und
- Erhitzen des beschichteten Substrates in einer Gasatmosphäre auf eine Beladungstemperatur T_{B} bei welcher Gasatome der Gasatmosphäre in die unterstöchiometrische Schicht eindiffundieren und die Schutzschicht ausgebildet wird.

Die unterstöchiometrisch aufgebrachte Schicht weist nach der Beschichtung eine Druckspannung, bedingt durch eine große Anzahl von atomaren Störungen (Gitterfehler etc.) in der Schicht auf. Zusätzlich weist die Schicht durch die Unterstöchiometrie ein Defizit an Atomen auf, wodurch reguläre Gitterplätze dieser Atome unbesetzt bleiben.

Die ursprünglichen atomaren Störungen, die die Ausgangsdruckspannung verursacht haben, würden durch Erhitzen (ohne Gasatmosphäre) des beschichteten Substrates auf Temperaturen oberhalb der Beschichtungstemperatur T_{Dep}ausgeheilt. Dadurch würden die ursprünglichen Druckspannungen verloren gehen und Zugspannungen, die durch einen höheren thermischen Ausdehnungskoeffizienten der Schicht gegenüber dem Substrat bei dem Herstellungsprozess entstanden sind, die Gesamtdruckbilanz dominieren. Dadurch käme es beim Abkühlen nach der Temperung zur Ausbildung von Rissen in der Schicht.

Während des Erhitzen des beschichteten Substrates auf eine Beladungstemperatur T_{B}, welche vorzugsweise oberhalb der Beschichtungstemperatur T_{dep} und unterhalb einer maximalen Belastungstemperatur Tₘₐₓ liegt, in einer geeigneten Gasatmosphäre gemäß der Erfindung, werden durch Diffusion von Gasatomen der Gasatmosphäre in die Schicht die unbesetzten regulären Gitterplätze aufgefüllt. Die zusätzlich in die Schicht eingebrachten Atome stellen Druckspannungszentren dar, so dass in der Gesamtdruckbilanz der Anteil an Druckspannungen erhöht wird. Dadurch wird das Erreichen des kritischen Zugspannungsniveau, bei welchem eine Rissbildung der Schicht beim Abkühlen auftritt, dauerhaft verhindert. Dieser Effekt kann vorzugsweise dadurch verstärkt werden, dass die Beschichtungstemperatur T_{dep} so gering wie möglich und unterhalb einer minimal notwendigen Beladungstemperatur T_{B} eingestellt wird.

Das erfindungsgemäße Verfahren eignet sich zur Herstellung unterschiedlichster beschichteter Substrate, die vor allem eine hohe Kratzfestigkeit und Temperaturbeständigkeit aufweisen müssen. Weiterhin sind beschichtete Substrate mit einem ansprechenden optischen Erscheinungsbild und je nach Substrat- und Schichtmaterial auch transparente beschichtete Substrate herstellbar.

Das Verfahren ist insbesondere geeignet für die Herstellung beschichteter Substrate aus Glas, Glaskeramik oder einem anderen nichtmetallischen kristallinen Material, insbesondere für die Herstellung von Kochflächen aus Glaskeramik, aber darauf nicht beschränkt. Hier stehen Anforderungen von hoher Kratzfestigkeit, Temperaturbeständigkeit und einem ansprechenden optischen Erscheinungsbild im Vordergrund, welche mit dem Verfahren erreicht werden können.

Die Schutzschicht wird vorzugsweise auf die zu schützende Fläche des Substrates, beispielsweise bei Kochflächen auf die Oberseite, aufgebracht. Ebenso kann es für bestimmte Anwendungsfälle zweckmäßig sein, ein Substrat allseitig, bzw. beidseitig zu beschichten.

Das Aufbringen der Schicht erfolgt mit einem reaktiven PVD-Verfahren (PVD - Physical Vapor Deposition - physikalische Abscheidung aus der Dampfphase). Zu den PVD-Verfahren im Sinne dieser Erfindung zählen Aufdampfen, Sputtern und Ionenplattieren. Bei reaktiven PVD-Verfahren läßt man das verdampfte bzw. zerstäubte Schichtausgangsmaterial mit einem in die Vakuumkammer eingelassenem Gas (Reaktivgas) reagieren, damit auf dem Substrat die gewünschte Verbindung entsteht.

Unterstöchiometrische Schichten werden bevorzugt erzeugt durch eine entsprechende Einstellung der Verfahrensparameter, insbesondere durch Einstellung der Verdampfungsrate und/oder der Restgaszusammensetzung. Beim Magnetronsputtern erfolgt die Erzeugung von unterstöchiometrischen Schichten vorzugsweise im sogenannten "transition mode", einem Arbeitsbereich zwischen den Arbeitsbereichen "metallic mode" (geringer Reaktivgasfluss, hohe Spannung, hohe Beschichtungsrate) und "oxide mode" (hoher Reaktivgasfluss, niedrigere Spannung, niedrige Beschichtungsrate). Der "transition mode" erlaubt in einem breiten Parameterbereich, die gezielte Einstellung der Schichtzusammensetzung, insbesondere die gezielte Herstellung der gewünschten Unterstöchiometrie.

Die Erzeugung von besonders kratzfesten und temperaturbeständigen Schichtmorphologien gelingt insbesondere mit PVD-Verfahren mit hohen Energieeinträgen, bei welchen sich Schichten mit einer dichten, überwiegend kristallinen Säulenstruktur ausbilden, insbesondere mittels Magnetronsputtern oder mittels Ionenstrahlsputtern.

Eine zusätzliche energetische Anreicherung der in atomaren Abmessungen erzeugten Schichtausgangsstoffe führt zu besonders dichten Schichten. Bevorzugt erfolgt die energetische Anreicherung durch einen Ionenstrahl, wobei der Ionenstrahl auf das Substrat gerichtet wird, während die Schicht aufwächst.

Die Energie der Ionen des unterstützenden Ionenstrahls liegt dabei zwischen 1 bis 2500 eV, bevorzugt zwischen 1 bis 800 eV, und besonders bevorzugt zwischen 20 bis 450 eV. Die Ionen-Energie und die Intensität des unterstützenden Ionenstrahls muss in jedem Fall so eingestellt werden, dass die Auftragsrate der Schichtausgangsstoffe größer bleibt, als die Abtragsrate der Schichtstoffe durch die zusätzliche Ionenquelle. Die Ionenstrahlunterstützung kann auch gegebenenfalls zeitweilig unterbrochen werden.

In Abhängigkeit von der gewählten Technik bestehen unterschiedliche Möglichkeiten, einen Ionenbeschuss der aufwachsenden Schicht zu realisieren. Unter Beachtung der vielfältigen Einstellmöglichkeiten hinsichtlich der Intensität und der Wahl der Ionen (Edelgase, Sauerstoff, Stickstoff etc.) und der geometrischen Anordnung der Ionenquellen in Bezug auf das zu beschichtende Substrat, lassen sich für den Fachmann diesbezüglich Einstellungen finden, mit denen das Verfahren ausführbar ist. In Prozessen, die Magnetronquellen einsetzen, gelingt die Ausführung beispielsweise durch den Einsatz eines sogenannten "unbalanced Magnetron", eines gepulsten Magnetrons, einer Mittelfrequenz-Magnetronquelle mit sehr hohen Wechselfrequenzen oder durch Anlegen einer negativen Bias-Spannung an das Substrat. In diesen Prozessen kann der vorteilhafte Ionenbeschuss der aufwachsenden Schicht durch Extraktion der Ionen aus dem Plasma der Materiälquelle realisiert werden.

Schutzschichten aus Metalloxiden, Metallnitriden, Metallcarbiden, Metalloxonitriden, Metallcarbonitriden und oder Metalloxocarbonitriden weisen in der Regel gute Härteeigenschaften auf, insbesondere dann, wenn durch die Einstellung der Prozessparameter die Schichten überwiegend kristallin und in dichten Säulenstrukturen aufwachsen.

In vorteilhaften Ausführungsformen des erfindungsgemäßen Verfahrens werden als Schichtausgangsstoffe zur Erzeugung derartiger Schichten entsprechende metallische Komponenten und/oder metallische Verbindungen in fester Form bereitgestellt.

Geeignete metallischen Komponenten und/oder Verbindungen umfassen insbesondere Si, Zr, Al, Ti, W, Cr, Y, Fe, Ta, Nb, Ni, Cu, Co, Mn, V und/oder Mo.

Vorzugsweise wird zur Beschichtung des Substrates mit einer unterstöchiometrische Metalloxidschicht zumindest ein Reaktivgas, vorzugsweise Sauerstoff, in die Vakuumkammer eingeleitet, wobei als Schichtausgangsstoff ein Metall oder ein Metalloxid bereitgestellt wird.

Außerdem kann es vorteilhaft sein, vorzugsweise bei Metalloxidschichten, mindestens ein zusätzliches Gas, beispielsweise Stickstoff, zur Optimierung der Abtragsrate bei der Erzeugung der Schichtstoffe bzw. zur Optimierung des Ionisationsgrades des Reaktivgases in das Vakuumsystem einzuspeisen.

Vorzugsweise wird zur Beschichtung des Substrates mit einer unterstöchiometrische Metallnitridschicht zumindest ein Reaktivgas, vorzugsweise N₂, N₂O oder NH₃, in die Vakuumkammer eingeleitet, wobei als Schichtausgangsstoff ein Metall oder ein Metallnitrid bereitgestellt wird.

Weiterhin wird vorzugsweise zur Beschichtung des Substrates mit einer unterstöchiometrische Metallcarbidschicht zumindest ein Reaktivgas, vorzugsweise CH₄, C₂H₆ oder CₓF_{y}, in die Vakuumkammer eingeleitet, wobei als Schichtausgangsstoff ein Metall oder ein Metallcarbid bereitgestellt wird.

Außerdem wird vorzugsweise zur Beschichtung des Substrates mit einer unterstöchiometrische Metalloxonitridschicht ein Reaktivgasgemisch aus sauerstoffhaltigen und stickstoffhaltigen Gasen, in die Vakuumkammer eingeleitet, wobei als Schichtausgangsstoff ein Metall, ein Metallnitrid oder ein Metalloxid bereitgestellt wird. Erfolgt die Beschichtung mit Metallnitrid bzw. Metalloxid als Schichtausgangsstoff, so kann eine unterstöchiometrische Schicht auch unter Zugabe mindestens eines Gases, d.h. eines sauerstoffhaltigen bzw. stickstoffhaltigen Gases erhalten werden.

Bei der Beschichtung des Substrates mit einer unterstöchiometrische Metallcarbonitridschicht wird ein Reaktivgasgemisch aus kohlenstoffhaltigen und stickstoffhaltigen Gasen in die Vakuumkammer eingeleitet, wobei als Schichtausgangsstoff ein Metall, ein Metallcarbid oder ein Metallnitrid bereitgestellt wird. Erfolgt die Beschichtung mit Metallcarbid bzw. Metallnitrid als Schichtausgangsstoff, so kann eine unterstöchiometrische Schicht auch unter Zugabe mindestens eines Gases, d.h. eines stickstoffhaltigen bzw. kohlenstoffhaltigen Gases erhalten werden.

Weiterhin wird vorzugsweise zur Beschichtung des Substrates mit einer unterstöchiometrische Metalloxocarbonitrid ein Reaktivgasgemisch aus kohlenstoffhaltigen, sauerstoffhaltigen und stickstoffhaltigen Gasen in die Vakuumkammer eingeleitet, wobei als Schichtausgangsstoff ein Metall, ein Metallcarbid, ein Metalloxid oder ein Metallnitrid bereitgestellt wird. Erfolgt die Beschichtung mit Metallcarbid bzw. einem Metalloxid bzw. einem Metallnitrid als Schichtausgangsstoff, so kann eine unterstöchiometrische Schicht auch unter Zugabe eines Gas bzw. Gasgemischs, dass mindestens Anteile der im Ausgangsmaterial nicht vorhandenen Reaktivgaskomponenten enthält, erhalten werden.

Es hat sich gezeigt, dass zur Herstellung von transparenten, optisch ansprechenden, kratzfesten und in hohem Maße temperaturstabilen beschichteten Substraten, vorzugsweise von Substraten aus Glas oder Glaskeramik, Zirkonoxidschichten, insbesondere Zirkonoxidschichten, welche eine stabilisierende Komponente zur Ausbildung einer temperaturstabilen Kristallphase des Zirkonoxides aufweisen, als Schutzschicht besonders geeignet ist.

Die stabilisierende Komponente in der abgeschiedenen Zirkonoxidschicht umfasst vorzugsweise ein Oxid aus der Gruppe Yttriumoxid, Calciumoxid, Magnesiumoxid, Tantaloxid, Nioboxid, Scandiumoxid, Titanoxid oder aus der Gruppe der Lanthanoid-Oxide, wie z.B. Lanthanoxid oder Ceriumoxid, insbesondere 0,5 bis 50 mol% Y₂O₃, vorzugsweise 1 bis 10 mol% Y₂O₃ und besonders bevorzugt 1,0 bis 7,5 mol% Y₂O₃. Als optimal erweist sich eine Zirkonoxidschicht mit 4 mol% (± 1 mol%) Y₂O₃ als stabilisierende Komponente.

Als Ausgangsmaterial zur Herstellung dieser Schichten wird bevorzugt eine Metalllegierung aus Zirkon und der stabilisierenden Komponente in der benötigten Konzentration verwendet. Bei bestimmten Verfahren, wie beispielsweise Co-Verdampfen, können jedoch auch getrennte Ausgangsmaterialen (Zirkon und stabilisierende Komponente) eingesetzt werden.

Eine weitere zweckmäßige Ausführung des Verfahrens ergibt sich, wenn statt hoch reinem nicht vollständig vom Hafnium befreites Zirkon eingesetzt wird.

Das Substrat wird in vorteilhaften Ausführungsformen mit einer Schicht, welche eine Schichtdicke im Bereich von 30 nm bis 20000 nm, bevorzugt von 500 nm bis 10000 nm und besonders bevorzugt von 1500 nm bis 5000 nm aufweist, beschichtet.

Nach der Beschichtung des Substrates mit einer unterstöchiometrischen Schicht wird das beschichtete Substrat in einer Gasatmosphäre auf eine Beladungstemperatur T_{B}, welche ausreichend hoch ist, um eine Beladung der Schicht mit Gasatomen zu ermöglichen, erhitzt.

Die Beschichtungstemperatur T_{dep} ist vorzugsweise so einzustellen, dass diese kleiner als die minimal notwendige Temperatur ist, bei der eine Beladung der Schicht erfolgen kann. Dabei ist es insbesondere in Hinsicht auf eine ökonomische Prozessführung zweckmäßig, das noch durch die Beschichtung erwärmte Substrat weiter zu erhitzen. Ein Abkühlen des beschichteten Substrates zwischen Beschichtung und dem Erhitzen in einer Gasatmosphäre ist jedoch auch möglich und insbesondere dann notwendig, wenn die Beladungstemperatur T_{B} unterhalb der Beschichtungstemperatur T_{dep} liegt.

Vorzugsweise ist der thermische Ausdehnungskoeffizient der Schicht größer als der des Substrats, was bei Glaskeramiksubstraten mit Nullausdehnung immer der Fall ist.

In zweckmäßigen Ausführungsformen des erfindungsgemäßen Verfahrens wird das beschichtete Substrat in einer Gasatmosphäre erhitzt, welche zumindest Gasatome des/der Reaktionsgases/e, welches/e für den reaktiven Beschichtungsprozess verwendet wurde/n, aufweist.

Bevorzugt wird das mit einer unterstöchiometrischen Metalloxidschicht beschichtete Substrat in einer Gasatmosphäre, welche zumindest ein sauerstoffhaltiges Gas aufweist, das mit einer unterstöchiometrischen Metallnitridschicht beschichtete Substrat in einer Gasatmosphäre, welche zumindest ein stickstoffhaltiges Gas aufweist, das mit einer unterstöchiometrischen Metallcarbidschicht beschichtete Substrat in einer Gasatmosphäre, welche zumindest ein kohlenstoffhaltiges Gas aufweist, das mit einer unterstöchiometrischen Metalloxonitridschicht beschichtete Substrat in einer Gasatmosphäre, welche zumindest ein stickstoffhaltiges Gas und/oder ein sauerstoffhaltiges Gas aufweist, das mit einer unterstöchiometrischen Metallcarbonitridschicht beschichtete Substrat in einer Gasatmosphäre, welche zumindest ein stickstoffhaltiges Gas und/oder ein kohlenstoffhaltiges Gas aufweist und/oder das mit einer unterstöchiometrischen Metalloxocarbonitridschicht beschichtete Substrat in einer Gasatmosphäre, welche zumindest ein stickstoffhaltiges Gas und/oder ein kohlenstoffhaltiges Gas und/oder ein sauerstoffhaltiges Gas aufweist, erhitzt.

In Abhängigkeit vom Zeitpunkt in der gesamten Produktionskette kann es erforderlich sein, die zu beschichtenden Substrate vor der Beschichtung einer Reinigung zu unterziehen. Eine Reinigung wird dann nicht notwendig erfolgen, wenn die Beschichtung unmittelbar an den letzten Heißschritt in der Herstellung eines Glas- bzw. Glaskeramikkörpers anschließt, da zu diesem Punkt sauberste Oberflächen vorliegen.

Die Reinigung der zu beschichtenden Substrate kann durch Verwendung mindestens eines geeigneten Reinigungsbades mit abschließender Trocknung erfolgen, um Verschmutzungen von der zu beschichtenden Oberfläche zu entfernen. In Abhängigkeit von den auftretenden Verschmutzungen kann es erforderlich sein, mehr als ein Reinigungsbad einzusetzen und zusätzliche Reinigungseffekte durch eine Beheizung und/oder Ultraschallanregung anzuwenden.

Es besteht weiterhin die Möglichkeit, die Reinigung in einer Vakuumkammer durch eine Plasmabehandlung mit Ionen, deren Energie vorzugsweise im Bereich von 10 bis 2500 eV, bevorzugt von 50 bis 1600 eV, und besonders bevorzugt von 100 bis 500 eV liegt, durchzuführen. Mögliche Ausführungsformen dafür sind beispielsweise der Beschuss des Substrates mit Ionen aus einer Ionenquelle oder das "Baden" der Probe im Plasma einer Glimmentladung. Dadurch wird eine besonders intensive Reinigung der Oberfläche von Fremdatomen und Adsorbaten erreicht. Sinnvolle Reinigungszeiten liegen zwischen einigen Sekunden bis zu einigen Minuten.

Außerdem ist es vorteilhaft, die Oberfläche des zu beschichtenden Substrates zu aktivieren. Die Aktivierung kann ebenfalls in einer Vakuumkammer durch eine Plasmabehandlung der Oberfläche, wie vor beschrieben, erfolgen. Die Reinigung und Aktivierung können dann gegebenenfalls in einem Prozessschritt erfolgen.

Insbesondere zur Verbesserung der Kristallinität der Schicht ist es vorteilhaft, vor Beginn und während der Beschichtung das zu beschichtende Substrat in der Vakuumkammer auf die Beschichtungstemperatur zu erwärmen, beispielsweise durch geeignete Heizelemente in der Vakuumkammer. Die Substrattemperatur kann zu Prozessbeginn bevorzugt zwischen 50°C und 550°C, besonders bevorzugt zwischen 100°C und 350°C eingestellt werden.

Weiterhin kann es erwünscht sein, eine besonders hohe Oberflächengüte des beschichteten Substrates zu erzielen. Dazu kann in einem oder mehreren abschließenden Polierschritten, die dazu geeignet sind, die geringe verbleibende Oberflächenrauhigkeit bis zu einem Rₐ-Wert von 1 nm zu verbessern, die Oberfläche nochmals nachgearbeitet werden.

Mit dem erfindungsgemäßen Verfahren sind auch mehrere Schutzschichten auf ein Substrat durch Wiederholung der Schritte Beschichten und Erhitzen herstellbar. In welcher Reihenfolge, Anzahl und mit welchen Materialien diese ausgebildet werden, hängt im wesentlichen von den noch weiter gewünschten optischen und/oder mechanischen Anforderungen an das beschichtete Substrat ab.

Des weiteren besteht die Möglichkeit, als Substrat ein bereits beliebig beschichtetes Substrat zur Verfügung zu stellen, auf welches die Schutzschicht gemäß der Erfindung aufgebracht wird.

Bei transparenten Schutzschichten können die zu beschichtenden Substrate unterhalb oder innerhalb der Schutzschichten zusätzlich dekoriert sein. Nichttransparente aber auch transparente Schutzschichten können auf der Schutzschicht zusätzlich dekoriert sein.

Die Erfindung soll im weiteren an Hand von Ausführungsbeispielen näher erläutert werden. Dazu zeigt
- Figur 1:: eine schematischen Darstellung der Schichtspannungen für oxidische Schichten auf einem Glaskeramiksubstrat
- Fig. 2:: die Transmissionskurven von Y-ZrO2 auf Ceran vor und nach einer Sauerstoffnachbeladung

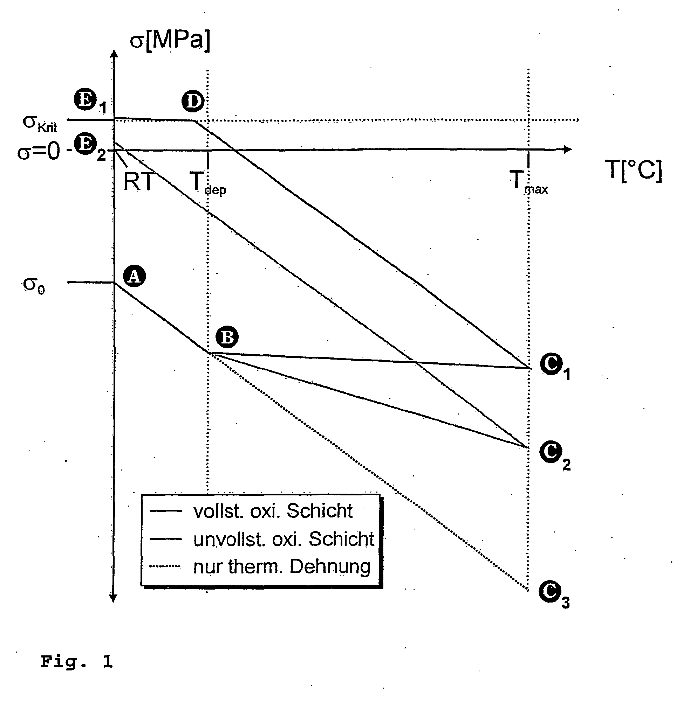

Fig. 1 zeigt einen schematischen Vergleich des Spannungsverhaltens von Beschichtungen, die vollständig oxidiert hergestellt wurden (schwarze Linie) und nicht vollständig oxidiert (graue Linie) aufgebracht wurden, während einer anschließenden Temperung in einer Sauerstoffatmosphäre.

### vollständig und unvollständig oxidierte Schicht:

Die Schichten weisen nach der Herstellung (Punkt A) starke Druckspannungen, bedingt durch eine große Anzahl von atomaren Störungen in der Schicht auf. Der Einfachheit halber sind diese Druckspannungen für vollständig oxidierte Schichten und unvollständig oxidierte Schichten als gleich angenommen.

Aufgrund der unterschiedlichen thermischen Ausdehnungskoeffizienten des Substrats aus Glaskeramik und der oxidischen Schichten (α_{Substrat} < α_{Schicht}) setzt sich der Ausgangsspannungszustand der Schichten aus einer Zugspannungskomponente bedingt durch T_{Dep} > RT (Raumtemperatur) und einer durch atomare Störstellen bedingten Druckspannungskomponente zusammen. Die Druckspannungskomponente überwiegt die Zugspannungskomponente.

Beim ersten Aufheizen der Schichten bis zur Beschichtungstemperatur (T_{Dep}) werden aufgrund der unterschiedlichen thermischen Ausdehnungskoeffizienten des Substrats und der Schichten (α_{Substrat} < α_{Schicht}) zusätzlich zu den vorhandenen Druckspannungen weitere, reversible Druckspannungen aufgebaut (Verlauf von A -> B). Es liegen keine atomaren Störstellen vor, die bis zu dieser Temperatur ausheilen könnten, da die Schichten während der Beschichtung diese Temperaturen durchlaufen haben und entsprechende Störstellen bereits bei der Herstellung wieder abgebaut wurden.

Ohne zusätzliche Effekte (Risse, Spannungsabbau, Abplatzen der Schicht etc.) würde bei weiterer Temperatursteigerung der gestrichelte Kurvenverlauf entstehen und die Druckspannungen im Punkt C3 bei der maximalen Temperatur Tₘₐₓ einen maximalen Wert erreichen.

### Vollständig oxidierte Schicht - schwarze Linie

Wird die Temperatur über T_{Dep} gesteigert, heilen sukzessive atomare Störungen im Gitter aus, was zu einem Abbau von Druckspannungen in der Schicht führt. Das Ausheilen bestimmter atomarer Störstellen benötigt eine gewisse Mindesttemperatur, um ablaufen zu können. Daher wird ein Ausheilen über den gesamten Temperaturbereich beobachtet. Gleichzeitig werden bei steigender Temperatur zusätzliche Druckspannungen aufgrund der Unterschiede in den thermischen Ausdehnungskoeffizienten von Substrat und Schicht aufgebaut.

Das Ausheilen der Störstellen und damit der Abbau der herstellungsbedingten Druckspannungen kompensiert den thermisch bedingten Anstieg der Druckspannungen, so dass der Verlauf von B -> C1 anstelle von B -> C3 beobachtet wird.

Da das Ausheilen von Störstellen bis Tₘₐₓ abgeschlossen ist, sinken beim Abkühlen nur die reversiblen thermischen Spannungen wieder ab. Es wird der Spannungsverlauf von C1 -> D beobachtet.

Beim Abkühlen wechselt der Spannungszustand der Schicht von Druckspannungen zu Zugspannungen, da ein wesentlicher Teil der Druckspannungen bedingt durch das Ausheilen der atomaren Störstellen die herstellungsbedingten Zugspannungen nicht mehr kompensieren kann und die thermischen Druckspannungen ebenfalls nicht mehr dafür ausreichen. Bei weiterem Abkühlen gehen die thermischen Druckspannungen zurück und die Zugspannungen steigen an. Bei Erreichen der für die Beschichtung kritischen Zugspannungen in Punkt D setzt Rissbildung ein.

Bei weiterem Abkühlen (Verlauf von D -> E) bilden sich immer mehr Risse, die ein weiteres Ansteigen der Zugspannungen verhindern, da durch die Risse Zugspannungen abgebaut werden.

### Unvollständig oxidierte Probe - graue Linie

Neben den Vorgängen (Ausheilen und thermische Druckspannungen) der vollständig oxidierten Schicht werden durch Eindiffundieren von Sauerstoffatomen aus der umgebenden Atmosphäre die Sauerstoffleerstellen in der Beschichtung aufgefüllt. Dieses Auffüllen führt zu zusätzlichen Druckspannungen in der Schicht, da die Sauerstoffatome das Gitter der Schicht gegenüber dem Ausgangszustand dehnen.

Das Ausheilen der Störstellen und damit der Abbau der herstellungsbedingten Druckspannungen kompensiert den thermisch bedingten Anstieg der Druckspannungen, zusätzlich tritt eine leichte Erhöhung der Druckspannungen durch den Einbau des Sauerstoffs auf. Deshalb wird der Verlauf B -> C2 anstelle von B -> C1 (vollständig oxidierte Schicht) beobachtet.

Der Effekt durch die Sauerstoffatome kann das Ausheilen der atomaren Fehlstellen nicht vollständig kompensieren, so dass der Verlauf von B -> C3 nicht beobachtet wird.

Da das Ausheilen von Störstellen bis Tₘₐₓ abgeschlossen ist und die zusätzlichen Sauerstoffatome auf regulären Gitterplätzen dauerhaft in der Schicht verbleiben, sinken beim Abkühlen nur die reversiblen thermischen Spannungen wieder ab. Es wird der Spannungsverlauf von C2 -> E2 beobachtet.

Je nach Größe des Effekts der nachträglich eingebrachten Sauerstoffatome ist prinzipiell ein Spannungszustand der Schicht zwischen Druckspannungen und der kritischen Zugspannung möglich. Das Beispiel zeigt einen Fall, bei dem zwar Zugspannungen bei RT (Raumtemperatur) auftreten, da diese aber kleiner als die kritischen Zugspannungen sind, bleibt die Schicht rissfrei.

### Ausführungsbeispiel: Herstellung einer Kochfläche aus Glaskeramik mit einer Schutzschicht aus Yttrium-Zirkondioxid

Als Substrat wird eine Glaskeramik-Platte, beispielsweise eine CERAN-Platte für Kochfelder mit einer Abmessung von 60 cm * 60 cm, zur Verfügung gestellt.

Das Substrat wird unmittelbar nach seiner Herstellung, im Anschluss an die Keramisierung, aus einer Herstellungsanlage über eine evakuierbare Schleuse in eine Beschichtungsanlage überführt. Die Beschichtungsanlage ist eine vertikale Anlage, die eine randlose Beschichtung der Substrate ermöglicht. Die Substrate werden einzeln in die Beschichtungsanlage überführt.

Die Beschichtungsanlage besteht aus drei Vakuumkammern, der Vorbehandlungskammer, der Beschichtungskammer und der Nachbehandlungskammer, welche über Shutter miteinander in Verbindung stehen.

Nach dem Einschleusen des Substrats bei Atmosphärendruck wird die Vorbehandlungskammer zunächst auf den Prozessdruck im Bereich von 2*10⁻⁵ mbar evakuiert. Mittels in der Kammer angeordneter Heizelemente wird eine Prozesstemperatur von ca. 200 °C eingestellt.

In der Vorbehandlungskammer wird das Substrat einer Reinigung in einem Argon-Plasma unterzogen. Der Plasmareinigungsvorgang dauert ca. 1 min. Anschließend wird das Substrat in die evakuierte Beschichtungskammer überführt.

Das Schichtausgangsmaterial ist metallisches Zirkon-Yttrium in einem Verhältnis 92:8, welches als Zr-Y Target in der Beschichtungskammer zur Verfügung gestellt wird. Als Reaktivgas wird ein Argon-Sauerstoff Gemisch in die Beschichtungskammer eingelassen. Der Kammerdruck beträgt ca. 3*10⁻³ mbar. Zum Sputtern des Schichtausgarigsmaterials werden Mittelfrequenz-Magnetrons eingesetzt. Mit in der Kammer angeordneten Heizelementen wird das Substrat auf der gewünschten Prozesstemperatur von 200 °C gehalten. Der Sauerstoffpartialdruck wird so eingestellt, dass die Sputterquellen im sog. "transition-mode" betrieben werden können. Speziell wird der Sauerstoffpartialdruck derart gewählt, dass durch eine hinreichend hohe dynamische Aufwachsrate (>35 nm*m/min) Schichten hergestellt werden, die ein leichtes Sauerstoffdefizit aufweisen. Die unterstöchiometrische Y-ZrO₂ Schicht wird bei einer Beschichtungstemperatur T_{Dep} von ca. 200 °C mit einer Schichtdicke von 2 µm abgeschieden. Dazu wird das Substrat über den Sputterquellen vor und zurück bewegt.

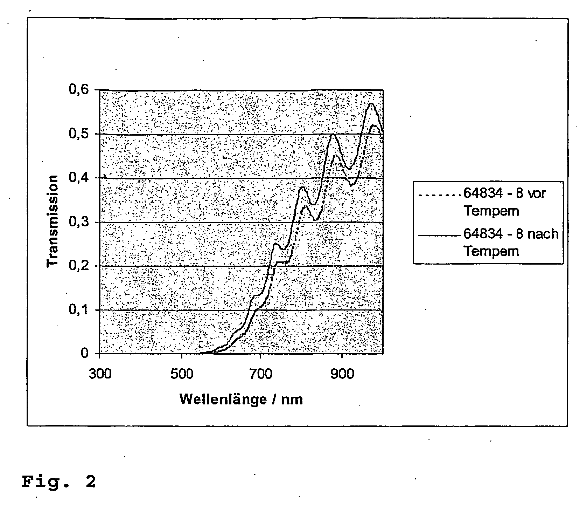

Das Sauerstoffdefizit bewirkt eine leichte Absorption in den Schichten. Wird der Transmissionsverlauf einer solchen Schicht auf einem Glaskeramiksubstrat vermessen, ergibt sich der in Fig. 2 dargestellte Verlauf der Transmissionskurve (gestrichelte Linie) mit der charakteristischen Modulation durch die hochbrechende 2µm dicke Y-ZrO₂-Schicht.

Anschließend wird das Substrat aus der Beschichtungskammer in die Nachbehandlungskammer überführt und für mindestens 30 min einer Sauerstoffnachbeladung durch Erhitzen in einer Sauerstoff-Gasatmosphäre unterzogen. Dazu wird das Substrat auf die Beladungstemperatur T_{B} von > 400°C aufgeheizt und ein Sauerstoffpartialdruck > 100 mbar in der Nachbehandlungskammer eingestellt.

Abschließend wird das mit der Schutzschicht beschichtete Substrat aus der Beschichtungsanlage ausgeschleust.

Eine Sauerstoffnachbeladung ist prinzipiell auch außerhalb der Beschichtungsanlage in einem geeigneten Ofen möglich.

Das Sauerstoffdefizit der unterstöchiometrischen Schicht konnte durch eine Temperaturbehandlung der Schicht in einer Sauerstoff-Gasatmosphäre durch die Nachbeladung mit Sauerstoffatomen ausgeglichen werden. Diese Nachbeladung bewirkt ein Verschwinden der Absorption, so dass bei erneuter Messung der Transmissionskurve (durchgezogene Linie), dargestellt in Fig. 2, eine um ca. 4% erhöhte Transmission gemessen wird.

Die so erhaltene beschichtete Kochfläche aus CERAN hat eine wesentlich erhöhte Kratzfestigkeit gegenüber einer unbeschichteten Kochfläche. Die Schutzschicht ist widerstandsfähig gegenüber mechanischen Belastungen, strukturstabil und rissfrei bei Temperaturbelastungen bis 800°C und hat ein ansprechendes optisches Design.

## Patentansprüche

1. Verfahren zum Herstellen eines Substrates mit zumindest einer Schutzschicht mit den Schritten:
- Bereitstellen des Substrates und zumindest eines Schichtausgangsstoffes in einer Vakuumkammer,
- Beschichten des Substrates mittels eines reaktiven PVD-Prozesses bei einer Beschichtungstemperatur T_{Dep}, wobei zumindest ein Reaktivgas in die Vakuumkammer eingeleitet wird und mit dem Schichtausgangsstoff oder -stoffen ein Reaktionsprodukt bildet, welches als unterstöchiometrische Schicht auf dem Substrat abgeschieden wird und eine Druckspannung aufweist, und
- Erhitzen des beschichteten Substrates in einer Gasatmosphäre auf eine Beladungstemperatur T_{B} bei der Gasatome der Gasatmosphäre in die unterstöchiometrische Schicht eindiffundieren, so daß in der Gesamtdruckbilanz der Anteil an Druckspannungen erhöht wird und die Schutzschicht ausgebildet wird.

2. Verfahren nach Anspruch 1,
**dadurch gekennzeichnet, dass**
ein Substrat aus Glas, Glaskeramik oder einem anderen nichtmetallischen kristallinen Material bereitgestellt wird.

3. verfahren nach einem der Ansprüche 1 oder 2,
**dadurch gekennzeichnet, dass**
die Beschichtungstemperatur T_{Dep} unterhalb der Beladungstemperatur T_{B} eingestellt wird.

4. Verfahren nach einem der vorhergehenden Ansprüche,
**dadurch gekennzeichnet, dass**
ein plattenförmiges Substrat bereitgestellt wird.

5. Verfahren nach Anspruch 4,
**dadurch gekennzeichnet, dass**
das Substrat zumindest auf einer Seite beschichtet wird.

6. Verfahren nach einem der vorhergehenden Ansprüche,
**dadurch gekennzeichnet, dass**
das Substrat mittels Magnetronsputtern beschichtet wird.

7. Verfahren nach einem der Ansprüche 1 bis 5,
**dadurch gekennzeichnet, dass**
das Substrat mittels Ionenstrahlsputtern beschichtet wird.

8. Verfahren nach einem der vorhergehenden Ansprüche,
**dadurch gekennzeichnet, dass**
die in atomaren Abmessungen erzeugten Schichtausgangsstoffe zusätzlich energetisch angereichert werden.

9. Verfahren nach Anspruch 8,
**dadurch gekennzeichnet, dass**
die in atomaren Abmessungen erzeugten Schichtausgangsstoffe beim Auftreffen auf das Substrat zusätzlich durch einen Ionenstrahl beschossen werden, wobei der Ionenstrahl auf das Substrat gerichtet wird.

10. Verfahren nach einem der vorhergehenden Ansprüche,
**dadurch gekennzeichnet, dass**
Schichtausgangsstoffe in fester Form als metallische Komponenten und/oder metallische Verbindungen bereitgestellt werden.

11. Verfahren nach Anspruch 10,
**dadurch gekennzeichnet, dass**
die metallischen Komponenten und/oder Verbindungen Si, Zr, Al, Ti, Cr, Y, Fe, Ta, Nb, Ni, Cu, Co, Mn, V und/oder Mo umfassen.

12. Verfahren nach einem der Ansprüche 10 oder 11,
**dadurch gekennzeichnet, dass**
zumindest ein Reaktivgas, vorzugsweise Sauerstoff, in die Vakuumkammer eingeleitet wird und eine unterstöchiometrische Metalloxidschicht auf dem Substrat abgeschieden wird.

13. Verfahren nach Anspruch 12,
**dadurch gekennzeichnet, dass**
mindestens ein zusätzliches Gas, vorzugsweise Stickstoff, zur Optimierung der Abtragsrate bei der Erzeugung der Schichtausgangsstoffe in atomaren Abmessungen und zur Optimierung der Entstehung von atomaren Sauerstoff, in das Vakuumsystem eingespeist wird.

14. Verfahren nach einem der Ansprüche 10 oder 11,
**dadurch gekennzeichnet, dass**
zumindest ein stickstoffhaltiges Reaktivgas, vorzugsweise N₂, N₂O oder NH₃, in die Vakuumkammer eingeleitet wird und eine unterstöchiometrische Metallnitridschicht auf dem Substrat abgeschieden wird.

15. Verfahren nach einem der Ansprüche 10 oder 11,
**dadurch gekennzeichnet, dass**
zumindest ein kohlenstoffhaltiges Reaktivgas, vorzugsweise CH₄, C₂H₆ oder CₓF_{y} in die Vakuumkammer eingeleitet wird und eine unterstöchiometrische Metallcarbidschicht auf dem Substrat abgeschieden wird.

16. Verfahren nach einem der Ansprüche 10 oder 11,
**dadurch gekennzeichnet, dass**
zumindest ein stickstoffhaltiges und/oder sauerstoffhaltiges Reaktivgas in die Vakuumkammer eingeleitet wird und eine unterstöchiometrische Metalloxonitridschicht auf dem Substrat abgeschieden wird.

17. Verfahren nach einem der Ansprüche 10 oder 11,
**dadurch gekennzeichnet, dass**
zumindest ein kohlenstoffhaltiges und/oder stickstoffhaltiges Reaktivgas in die Vakuumkammer eingeleitet wird und eine unterstöchiometrische Metallcarbonitridschicht auf dem Substrat abgeschieden wird.

18. Verfahren nach einem der Ansprüche 10 oder 11,
**dadurch gekennzeichnet, dass**
zumindest ein kohlenstoffhaltiges und/oder stickstoffhaltiges und/oder sauerstoffhaltiges Reaktivgas in die Vakuumkammer eingeleitet wird und eine unterstöchiometrische Metalloxocarbonitridschicht auf dem Substrat abgeschieden wird.

19. Verfahren nach einem der Ansprüche 11 bis 13,
**dadurch gekennzeichnet, dass**
als Schichtausgangsstoff Zirkon bereitgestellt wird und als Reaktivgas zumindest Sauerstoff in die Vakuumkammer eingeleitet wird.

20. Verfahren nach Anspruch 19,
**dadurch gekennzeichnet, dass**
zur Erzeugung einer unterstöchiometrischen Zirkonoxidschicht in einer temperaturstabilen Kristallphase Zirkon, welches eine stabilisierende Komponente aufweist, als Schichtausgangsstoff bereit gestellt wird.

21. Verfahren nach Anspruch 20,
**dadurch gekennzeichnet, dass**
als stabilisierende Komponente ein Element aus der Gruppe Yttrium, Calcium, Magnesium, Tantal, Niob, Scandium, Titan oder aus der Gruppe der Lanthanoide, wie z.B. Lanthan oder Cerium, bereitgestellt wird.

22. Verfahren nach Anspruch 19 bis 21,
**dadurch gekennzeichnet, dass**
eine unterstöchiometrische Schicht aus Zirkonoxid mit
0,5 bis 50 mol% Y₂O₃, vorzugsweise 1 bis 10 mol% Y₂O₃ und besonders bevorzugt 1,0 bis 7,5 mol% Y₂O₃ als stabilisierende Komponente abgeschieden wird.

23. Verfahren nach Anspruch 22,
**dadurch gekennzeichnet, dass**
eine unterstöchiometrische Schicht aus Zirkonoxid mit
4 mol% (± 1 mol%) Y₂O₃ als stabilisierende Komponente abgeschieden wird.

24. Verfahren nach einem der Ansprüche 19 bis 23,
**dadurch gekennzeichnet,**
**dass** als weiterer Schichtausgangsstoff Hafnium bereitgestellt wird.

25. verfahren nach einem der vorhergehenden Ansprüche,
**dadurch gekennzeichnet, dass**
das Substrat mit einer Schicht, welche eine Schichtdicke im Bereich von 30 nm bis 20000 nm, bevorzugt von 500 nm bis 10000 nm und besonders bevorzugt von 1500 nm bis 5000 nm aufweist, beschichtet wird.

26. Verfahren nach einem der vorhergehenden Ansprüche,
**dadurch gekennzeichnet, dass**
das beschichtete Substrate in einer Gasatmosphäre auf eine Temperatur oberhalb einer minimal notwendigen Beladungstemperatur T_{B} erhitzt wird.

27. Verfahren nach einem der vorhergehenden Ansprüche,
**dadurch gekennzeichnet, dass**
das beschichtete Substrat in einer Gasatmosphäre, welche zumindest Gasatome des Reaktionsgases aufweist, erhitzt wird.

28. Verfahren nach Anspruch 27,
**dadurch gekennzeichnet, dass**
das mit einer unterstöchiometrischen Metalloxidschicht beschichtete Substrat in einer Gasatmosphäre, welche zumindest Sauerstoff aufweist, erhitzt wird.

29. Verfahren nach Anspruch 27,
**dadurch gekennzeichnet, dass**
das mit einer unterstvchiometrischen Metallnitridschicht beschichtete Substrat in einer Gasatmosphäre, welche zumindest ein stickstoffhaltiges Gas aufweist, erhitzt wird.

30. Verfahren nach Anspruch 27,
**dadurch gekennzeichnet, dass**
das mit einer unterstöchiometrischen Metallcarbidschicht beschichtete Substrat in einer Gasatmosphäre, welche zumindest ein kohlenstoffhaltiges Gas aufweist, erhitzt wird.

31. Verfahren nach Anspruch 27,
**dadurch gekennzeichnet, dass**
das mit einer unterstöchiometrischen Metalloxonitridschicht beschichtete Substrat in einer Gasatmosphäre, welche zumindest ein sauerstoffhaltiges Gas und/oder ein stickstoffhaltiges Gas aufweist, erhitzt wird.

32. Verfahren nach Anspruch 27,
**dadurch gekennzeichnet, dass**
das mit einer unterstöchiometrischen Metallcarbonitridschicht beschichtete Substrat in einer Gasatmosphäre, welche zumindest ein stickstoffhaltiges und/oder kohlenstoffhaltiges Gas aufweist, erhitzt wird.

33. Verfahren nach Anspruch 27,
**dadurch gekennzeichnet, dass**
das mit einer unterstöchiometrischen Metalloxocarbonitridschicht beschichtete Substrat in einer Gasatmosphäre, welche zumindest ein sauerstoffhaltiges Gas und/oder stickstoffhaltiges Gas und/oder kohlenstoffhaltiges Gas aufweist, erhitzt wird.

34. Verfahren nach einem der vorhergehenden Ansprüche
**dadurch gekennzeichnet, dass**
das Substrat vor der Beschichtung vorbehandelt wird.

35. Verfahren nach Anspruch 34,
**dadurch gekennzeichnet, dass**
die Oberfläche des Substrates vor der Beschichtung einer Reinigung unterzogen wird.

36. Verfahren nach Anspruch 35,
**dadurch gekennzeichnet, dass**
die Reinigung in einer Vakuumkammer durch eine Plasmabehandlung mit Ionen erfolgt, deren Energie vorzugsweise im Bereich von 1 bis 2500 eV, bevorzugt von 50 bis 1600 eV, und besonders bevorzugt von 100 bis 500 eV liegt.

37. Verfahren nach Anspruch 34,
**dadurch gekennzeichnet, dass**
die Oberfläche des Substrates vor der Beschichtung aktiviert wird.

38. Verfahren nach Anspruch 37,
**dadurch gekennzeichnet, dass**
die Aktivierung in einer Vakuumkammer durch eine Plasmabehandlung mit Ionen erfolgt, deren Energie vorzugsweise im Bereich von 1 bis 2500 eV, bevorzugt von 50 bis 1600 eV, und besonders bevorzugt von 100 bis 500 eV liegt.

39. Verfahren nach Anspruch 35 bis 38,
**dadurch gekennzeichnet, dass**
die Reinigung und Aktivierung in einem Prozessschritt erfolgen.

40. Verfahren nach einem der vorhergehenden Ansprüche,
**dadurch gekennzeichnet, dass**
das Substrat zumindest vor dem Abscheiden der Schichtausgangsstoffe auf Prozesstemperaturen zwischen 50° C und 550° C, bevorzugt zwischen 100° C und 350° C, erwärmt wird.

## Claims

1. Method for producing a substrate with at least one protective layer, comprising the steps:
- provision of the substrate and at least one layer starting material in a vacuum chamber,
- coating of the substrate by means of a reactive PVD process at a coating temperature T_{Dep}, whereby at least one reactive gas is introduced into the vacuum chamber and forms, with the layer starting material or materials, a reaction product which is deposited on the substrate as an under-stoichiometric layer and has a compressive stress,
- heating of the coated substrate in a gas atmosphere to a charging temperature T_{B}, at which gas atoms of the gas atmosphere diffuse into the under-stoichiometric layer in such a way that the proportion of compressive stresses in the overall pressure balance is increased and the protective layer is formed.

2. Method according to claim 1,
**characterised in that**
a substrate made of glass, glass ceramic or another non-metallic, crystalline material is provided.

3. Method according to one of the claims 1 or 2,
**characterised in that**
the coating temperature T_{Dep} is set below the charging temperature T_{B}.

4. Method according to one of the preceding claims,
**characterised in that**
a plate-type substrate is provided.

5. Method according to claim 4,
**characterised in that**
the substrate is coated on at least one side.

6. Method according to one of the preceding claims,
**characterised in that**
the substrate is coated by means of magnetron sputtering.

7. Method according to one of the claims 1 to 5,
**characterised in that**
the substrate is coated by means of ion beam sputtering.

8. Method according to one of the preceding claims,
**characterised in that**
the layer starting materials produced in atomic dimensions are, in addition, energetically enriched.

9. Method according to claim 8
**characterised in that**
the layer starting materials produced in atomic dimensions, when contacting the substrate, are additionally shot through an ion beam, whereby the ion beam is directed at the substrate.

10. Method according to one of the preceding claims,
**characterised in that**
layer starting materials are provided in solid form as metallic components and / or metallic compounds.

11. Method according to claim 10,
**characterised in that**
the metallic components and / or compounds comprise Si, Zr, Al, Ti, Cr, Y, Fe, Ta, Nb, Ni, Cu, Co, Mn, V and / or Mo.

12. Method according to one of the claims 10 or 11,
**characterised in that**
at least one reactive gas, preferably oxygen, is introduced into the vacuum chamber, and an under-stoichiometric metal oxide layer is deposited on the substrate.

13. Method according to claim 12,
**characterised in that**
at least one additional gas, preferably nitrogen, is fed into the vacuum system in order to optimise the ablation rate in the production of the layer starting materials in atomic dimensions and to optimise the production of atomic oxygen.

14. Method according to one of the claims 10 or 11,
**characterised in that**
at least one nitrogen-containing reactive gas, preferably N₂, N₂O or NH₃, is introduced into the vacuum chamber and an under-stoichiometric metal nitride layer is deposited on the substrate.

15. Method according to one of the claims 10 or 11,
**characterised in that**
at least one carbon-containing reactive gas, preferably CH₄, C₂H₆ or CₓF_{y}, is introduced into the vacuum chamber and an under-stoichiometric metal carbide layer is deposited on the substrate.

16. Method according to one of the claims 10 or 11,
**characterised in that**
at least a nitrogen-containing and / or oxygen-containing reactive gas is introduced into the vacuum chamber and an under-stoichiometric metal oxonitride layer is deposited on the substrate.

17. Method according to one of the claims 10 or 11,
**characterised in that**
at least a carbon-containing and / or nitrogen-containing reactive gas is introduced into the vacuum chamber and an under-stoichiometric metal carbonitride layer is deposited on the substrate.

18. Method according to one of the claims 10 or 11,
**characterised in that**
at least a carbon-containing and / or nitrogen-containing and / or oxygen-containing reactive gas is introduced into the vacuum chamber and an under-stoichiometric metal oxocarbonitride layer is deposited on the substrate.

19. Method according to one of the claims 11 to 13,
**characterised in that**
zirconium is used as a layer starting material and at least oxygen is introduced into the vacuum chamber as a reactive gas.

20. Method according to claim 19,
**characterised in that**
for the production of an under-stoichiometric zirconium oxide layer in a temperature-stable crystal phase, zirconium which comprises a stabilising component is provided as a layer starting material.

21. Method according to claim 20,
**characterised in that**
an element of the group yttrium, calcium, magnesium, tantalum, niobium, scandium, titanium or of the group of lanthanoides such as lanthanium or cerium is provided as a stabilising component.

22. Method according to claims 19 to 21,
**characterised in that**
an under-stoichiometric layer of zirconium oxide with 0.5 to 50 mol% Y₂O₃, preferably 1 to 10 mol% Y₂O₃ and particularly preferably 1.0 to 7.5 mol% Y₂O₃ is deposited as a stabilising component.

23. Method according to claim 22,
**characterised in that**
an under-stoichiometric layer of zirconium oxide with 4 mol% (+/- 1 mol%) Y₂O₃ is deposited as a stabilising component.

24. Method according to one of the claims 19 to 23,
**characterised in that**
hafnium is provided as a further layer starting material.

25. Method according to one of the preceding claims,
**characterised in that**
the substrate is coated with a layer which has a layer thickness in the range of 30 nm to 20,000 nm, preferably 500 nm to 10,000 nm and particularly preferably 1500 nm to 5000 nm.

26. Method according to one of the preceding claims,
**characterised in that**
the coated substrate is heated in a gas atmosphere to a temperature above a minimum necessary charging temperature T_{B}.

27. Method according to one of the preceding claims,
**characterised in that**
the coated substrate is heated in a gas atmosphere which comprises at least gas atoms of the reaction gas.

28. Method according to claim 27,
**characterised in that**
the substrate coated with an under-stoichiometric metal oxide layer is heated in a gas atmosphere which comprises at least oxygen.

29. Method according to claim 27,
**characterised in that**
the substrate coated with an under-stoichiometric metal nitride layer is heated in a gas atmosphere which comprises at least a nitrogen-containing gas.

30. Method according to claim 27,
**characterised in that**
the substrate coated with an under-stoichiometric metal carbide layer is heated in a gas atmosphere which comprises at least a carbon-containing gas.

31. Method according to claim 27,
**characterised in that**
the substrate coated with an under-stoichiometric metal oxonitride layer is heated in a gas atmosphere which comprises at least an oxygen-containing gas and / or a nitrogen-containing gas.

32. Method according to claim 27,
**characterised in that**
the substrate coated with an under-stoichiometric metal carbonitride layer is heated in a gas atmosphere which comprises at least a nitrogen-containing and / or carbon-containing gas.

33. Method according to claim 27,
**characterised in that**
the substrate coated with an under-stoichiometric metal oxocarbonitride layer is heated in a gas atmosphere which comprises at least an oxygen-containing gas and / or nitrogen-containing gas and / or carbon-containing gas.

34. Method according to one of the preceding claims,
**characterised in that**
the substrate is pre-treated before coating.

35. Method according to claim 34,
**characterised in that**
the surface of the substrate is subjected to purification before coating.

36. Method according to claim 35,
**characterised in that**
the purification takes place in a vacuum chamber through plasma treatment with ions, the energy of which is preferably in the range of 1 to 2500 eV, more preferably 50 to 1600 eV and particularly preferably 100 to 500 eV.

37. Method according to claim 34,
**characterised in that**
the surface of the substrate is activated before coating.

38. Method according to claim 37,
**characterised in that**
the activation takes place in a vacuum chamber through plasma treatment with ions, the energy of which is preferably in the range of 1 to 2500 eV, more preferably 50 to 1600 eV and particularly preferably 100 to 500 eV.

39. Method according to claims 35 to 38,
**characterised in that**
the purification and activation take place in one process step.

40. Method according to one of the preceding claims,
**characterised in that**
the substrate is heated, before the deposition of the layer starting materials, to process temperatures between 50°C and 550°C, preferably between 100°C and 350°C.

## Revendications

1. Procédé de production d'un substrat portant au moins une couche protectrice, comprenant les étapes de :
- mise en place du substrat et d'au moins une matière de départ pour la couche dans une chambre à vide,
- revêtement du substrat par un procédé PVD réactif à une température de revêtement T_{Dep}, dans lequel au moins un gaz réactif est introduit dans la chambre à vide et forme avec la ou les matières de départ de la couche un produit de réaction qui se dépose sur le substrat en une couche sous-stoechiométrique et présente une tension de compression, et
- chauffage du substrat revêtu dans une atmosphère de gaz à une température de charge T_{B} à laquelle des atomes de gaz de l'atmosphère gazeuse s'incorporent par diffusion à la couche sous-stoechiométrique de façon telle que la part des tensions de compression dans le bilan de pression totale est élevée et que la couche protectrice est formée.

2. Procédé suivant la revendication 1, **caractérisé en ce qu'**un substrat en verre, en vitrocéramique ou en une autre matière cristalline non métallique est mis en place.

3. Procédé suivant la revendication 1 ou 2, **caractérisé en ce que** la température de revêtement T_{Dep} est réglée au-dessous de la température de charge T_{B}.

4. Procédé suivant l'une des revendications précédentes, **caractérisé en ce qu'**un substrat de forme plate est mis en place.

5. Procédé suivant la revendication 4, **caractérisé en ce que** le substrat est revêtu au moins d'un côté.

6. Procédé suivant l'une des revendications précédentes, **caractérisé en ce que** le substrat est revêtu par pulvérisation au magnétron.

7. Procédé suivant l'une des revendications 1 à 5, **caractérisé en ce que** le substrat est revêtu par pulvérisation par faisceau ionique.

8. Procédé suivant l'une des revendications précédentes, **caractérisé en ce que** les matières de départ pour la couche produites en dimensions atomiques sont en outre enrichies en énergie.

9. Procédé suivant la revendication 8, **caractérisé en ce que** les matières de départ de la couche produites en dimensions atomiques sont en outre bombardées par un faisceau ionique au moment de leur impact sur le substrat, le faisceau ionique étant dirigé sur le substrat.

10. Procédé suivant l'une des revendications précédentes, **caractérisé en ce que** les matières de départ de la couche sont mises en place sous forme solide comme composants métalliques et/ou comme composés métalliques.

11. Procédé suivant la revendication 10, **caractérisé en ce que** les composants et/ou les composés métalliques comprennent Si, Zr, Al, Ti, Cr, Y, Fe, Ta, Nb, Ni, Cu, Co, Mn, V et/ou Mo.

12. Procédé suivant l'une des revendications 10 ou 11, **caractérisé en ce qu'**au moins un gaz réactif, avantageusement l'oxygène, est introduit dans la chambre à vide et une couche sous-stoechiométrique d'oxyde métallique est déposée sur le substrat.

13. Procédé suivant la revendication 12, **caractérisé en ce qu'**au moins un autre gaz, avantageusement de l'azote, est injecté dans le système à vide pour optimiser la vitesse d'érosion lors de la production des matières de départ de la couche en dimensions atomiques et pour optimiser la formation d'oxygène atomique.

14. Procédé suivant l'une des revendications 10 ou 11, **caractérisé en ce qu'**au moins un gaz réactif contenant de l'azote, avantageusement N₂, N₂O ou NH₃, est introduit dans la chambre à vide et une couche sous-stoechiométrique sur nitrure métallique est déposée sur le substrat.

15. Procédé suivant l'une des revendications 10 ou 11, **caractérisé en ce qu'**au moins un gaz réactif contenant du carbone, avantageusement CH₄, C₂H₆ ou CₓF_{y} est introduit dans la chambre à vide et une couche sous-stoechiométrique de carbure métallique est déposée sur le substrat.

16. Procédé suivant l'une des revendications 10 ou 11, **caractérisé en ce qu'**au moins un gaz réactif contenant de l'azote et/ou contenant de l'oxygène est introduit dans la chambre à vide et une couche sous-stoechiométrique d'oxonitrure métallique est déposée sur le substrat.

17. Procédé suivant l'une des revendications 10 ou 11, **caractérisé en ce qu'**au moins un gaz réactif contenant du carbone et/ou contenant de l'azote est introduit dans la chambre à vide et une couche sous-stoechiométrique de carbonitrure métallique est déposée sur le substrat.

18. Procédé suivant l'une des revendications 10 ou 11, **caractérisé en ce qu'**au moins un gaz réactif contenant du carbone et/ou contenant de l'azote et/ou contenant de l'oxygène est introduit dans la chambre à vide et une couche sous-stoechiométrique d'oxocarbonitrure métallique est déposée sur le substrat.

19. Procédé suivant l'une des revendications 11 à 13, **caractérisé en ce que** du zirconium est mis en place comme matière de départ pour la couche et au moins de l'oxygène est introduit comme gaz réactif dans la chambre à vide.

20. Procédé suivant la revendication 19, **caractérisé en ce que** du zirconium qui présente un composant stabilisateur est mis en place comme matière de départ de la couche pour la production d'une couche sous-stoechiométrique d'oxyde de zirconium dans une phase cristalline stable à la chaleur.

21. Procédé suivant la revendication 20, **caractérisé en ce que** le composant stabilisateur rendu disponible est un élément du groupe yttrium, calcium, magnésium, tantale, niobium, scandium, titane ou du groupe des lanthanides, par exemple le lanthane ou le cérium.

22. Procédé suivant la revendication 19 à 21, **caractérisé en ce qu'**une couche sous-stoechiométrique d'oxyde de zirconium est déposée avec, comme composant stabilisateur, 0,5 à 50 mol % de Y₂O₃, avantageusement 1 à 10 mol % de Y₂O₃, et tout particulièrement 1,0 à 7,5 mol % de Y₂O₃.

23. Procédé suivant la revendication 22, **caractérisé en ce qu'**une couche sous-stoechiométrique d'oxyde de zirconium est déposée avec, comme composant stabilisateur, 4 mol % (± 1 mol %) de Y₂O₃.

24. Procédé suivant l'une des revendications 19 à 23, **caractérisé en ce que** du hafnium est prévu comme autre matière de départ de la couche.

25. Procédé suivant l'une des revendications précédentes, **caractérisé en ce que** le substrat est revêtu d'une couche qui présente une épaisseur comprise dans une plage de 30 nm à 20 000 nm, avantageusement de 500 nm à 10 000 nm, et notamment de 1500 nm à 5000 nm.

26. Procédé suivant l'une des revendications précédentes, **caractérisé en ce que** le substrat revêtu est chauffé en atmosphère gazeuse à une température au-dessus d'une température de charge T_{B} minimale nécessaire.

27. Procédé suivant l'une des revendications précédentes, **caractérisé en ce que** le substrat revêtu est chauffé dans une atmosphère gazeuse qui contient au moins des atomes du gaz de réaction.

28. Procédé suivant la revendication 27, **caractérisé en ce que** le substrat revêtu d'une couche sous-stoechiométrique d'oxyde métallique est chauffé dans une atmosphère gazeuse qui contient au moins de l'oxygène.

29. Procédé suivant la revendication 27, **caractérisé en ce que** le substrat revêtu d'une couche sous-stoechiométrique de nitrure métallique est chauffé dans une atmosphère gazeuse qui comprend au moins un gaz contenant de l'azote.

30. Procédé suivant la revendication 27, **caractérisé en ce que** le substrat revêtu d'une couche sous-stoechiométrique de carbure métallique est chauffé dans une atmosphère gazeuse qui comprend au moins un gaz contenant du carbone.

31. Procédé suivant la revendication 27, **caractérisé en ce que** le substrat revêtu d'une couche sous-stoechiométrique d'oxonitrure métallique est chauffé dans une atmosphère gazeuse qui comprend au moins un gaz contenant de l'oxygène et/ou un gaz contenant de l'azote.

32. Procédé suivant la revendication 27, **caractérisé en ce que** le substrat revêtu d'une couche sous-stoechiométrique de carbonitrure métallique est chauffé dans une atmosphère gazeuse qui comprend au moins un gaz contenant de l'azote et/ou un gaz contenant du carbone.

33. Procédé suivant la revendication 27, **caractérisé en ce que** le substrat revêtu d'une couche sous-stoechiométrique d'oxocarbonitrure métallique est chauffé dans une atmosphère gazeuse qui comprend au moins un gaz contenant de l'oxygène et/ou un gaz contenant de l'azote et/ou un gaz contenant du carbone.

34. Procédé suivant l'une des revendications précédentes, **caractérisé en ce que** le substrat est prétraité avant le revêtement.

35. Procédé suivant la revendication 34, **caractérisé en ce que** la surface du substrat est soumise à un nettoyage avant le revêtement.

36. Procédé suivant la revendication 35, **caractérisé en ce que** le nettoyage est effectué dans une chambre à vide par un traitement au plasma avec des ions dont l'énergie se situe avantageusement dans une plage de 1 à 2500 eV, mieux encore de 50 à 1600 eV, et en particulier de 100 à 500 eV.

37. Procédé suivant la revendication 34, **caractérisé en ce que** la surface du substrat est activée avant le revêtement.

38. Procédé suivant la revendication 37, **caractérisé en ce que** l'activation est effectuée dans une chambre à vide par un traitement au plasma avec des ions dont l'énergie se situe avantageusement dans une plage de 1 à 2500 eV, mieux encore de 50 à 1600 eV, et en particulier de 100 à 500 eV.

39. Procédé suivant la revendication 35 à 38, **caractérisé en ce que** le nettoyage et l'activation sont conduits dans une seule et même étape.

40. Procédé suivant l'une des revendications précédentes, **caractérisé en ce que** le substrat est chauffé, au moins avant le dépôt des matières de départ formant la couche, à des températures de traitement comprises entre 50°C et 550°C, avantageusement entre 100°C et 350°C.
